# EUROPEAN PATENT APPLICATION

(11) **EP 4 513 548 A1**
(43) Date of publication of application: **26.02.2025**
(21) Application number: 23192683.3
(22) Date of filing: 22.08.2023
(51) Int. Cl.: H01L 23/31, H01L 25/16

(54) **ELECTRONIC COMPONENT AND ARRANGEMENT**

(71) Applicant: Murata Manufacturing Co., Ltd., Nagaokakyo-shi, Kyoto 617-8555 (JP)
(72) Inventor: Syrjänen, Teppo, 00400 Helsinki (FI)
(74) Representative: Boco IP Oy Ab

(57) **Abstract**

An electronic component (1) comprises a package (2) with a top side (3) and a bottom side (4), at least one electronic chip (5) housed within an enclosure (6) inside the package (2), and a plurality of electronic leads (7) protruding from the package (2) and configured to extend from at least two sides (9, 11) of the package at least in a first direction (12) extending from the top side (3) of the package towards the bottom side (4) of the package. The package (2) comprises on the bottom side (4) of the package (2) at least one recess (13). The recess (13) is provided within an area (14) defined by outer edges (15, 16) of the package (2) and the electronic leads (7) and extends at least from the bottom side (4) towards the top side (3) of the package. The recess (13) is configured to define within said area (14) a space (20) between the package and a plane defined by bottom surfaces (23) of the electronic leads (7). The space (20) is designed to receive at least one discrete component (41).

## Description

### FIELD OF THE DISCLOSURE

This disclosure relates to electronic components, and particularly to the component packaging which surrounds electronic chips.

### BACKGROUND OF THE DISCLOSURE

Electronic chips, which may also be called dies, are usually prepared by manufacturing various electronic structures on a substrate and cutting the substrate into small, chip-size pieces. Each chip can then be placed inside a protective package which forms an enclosure where the chip is protected from the surrounding environment. The chip can be mechanically attached to a support structure inside the enclosure, such as a die pad, and electrically connected to contacts which extend outside of the enclosure. The packaged chip thereby forms an electronic component which can be mounted on a circuit board.

There is a general trend to make many kinds of electronic devices smaller, provide small devices with more electronic components, and, in general, decrease the size of electronic components.

### BRIEF DESCRIPTION OF THE DISCLOSURE

An object of the present disclosure is to provide a new apparatus.

The object of the disclosure is achieved by an apparatus and an arrangement which are characterized by what is stated in the independent claims. Some preferred embodiments of the disclosure are disclosed in the dependent claims.

The disclosure is based on the idea of designing the side of the electronic component configured to be provided towards a printed circuit board (PCB) to provide space between the electronic component and the printed circuit board for at least one discrete component. This enables saving use of effective area of the printed circuit board.

### BRIEF DESCRIPTION OF THE DRAWINGS

In the following the disclosure will be described in greater detail by means of preferred embodiments with reference to the accompanying drawings, in which
Figure 1 illustrates an electronic component according to an embodiment schematically seen from a first side;
Figure 2 illustrates the embodiment of Figure 1 schematically seen from a second side;
Figure 3 illustrates an electronic component according to another embodiment schematically seen from a first side;
Figure 4 illustrates the embodiment of Figure 3 schematically seen from the first side in cross section;
Figure 5 illustrates an electronic component according to a further embodiment schematically seen from a first side;
Figure 6 illustrates an electronic component according to a further embodiment schematically seen from a first side;
Figure 7 illustrates an electronic component according to an embodiment schematically seen from the bottom side;
Figure 8 illustrates an electronic component according to another embodiment schematically seen from the bottom side;
Figure 9 illustrates an electronic component according to a further embodiment schematically seen from the bottom side;
Figure 10 illustrates an arrangement according to an embodiment seen from a first side; and
Figure 11 illustrates an arrangement according to another embodiment seen from a first side.

### DETAILED DESCRIPTION

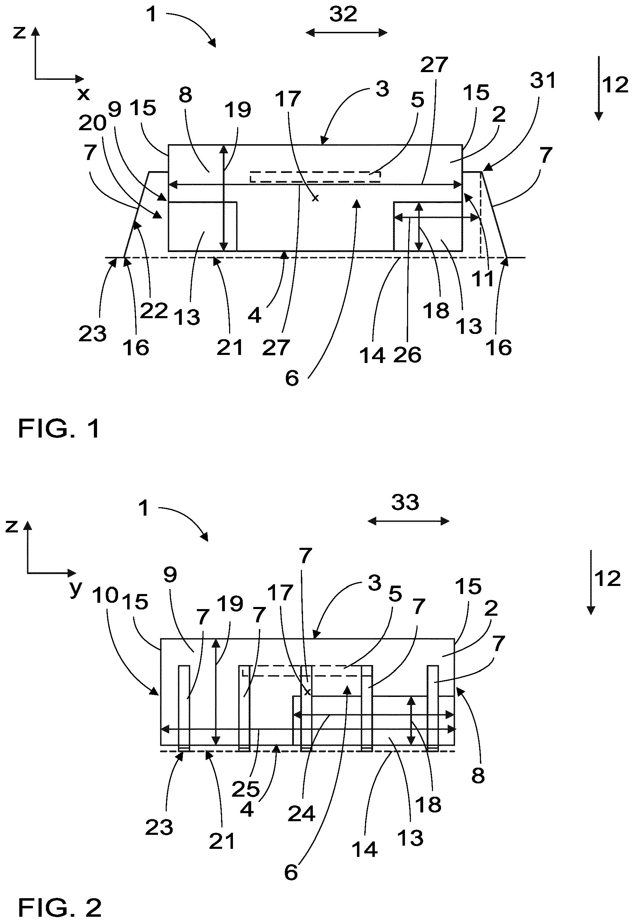

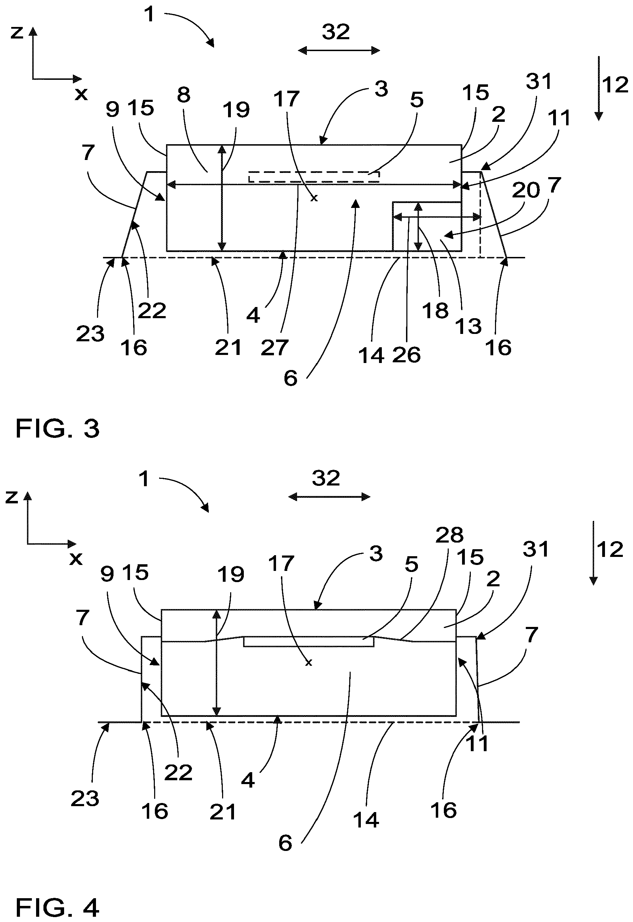

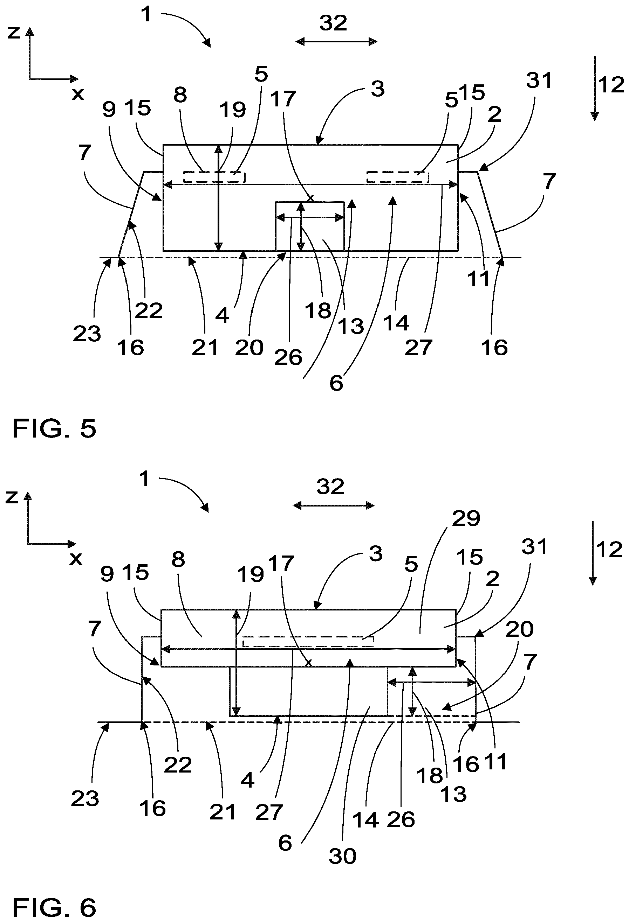

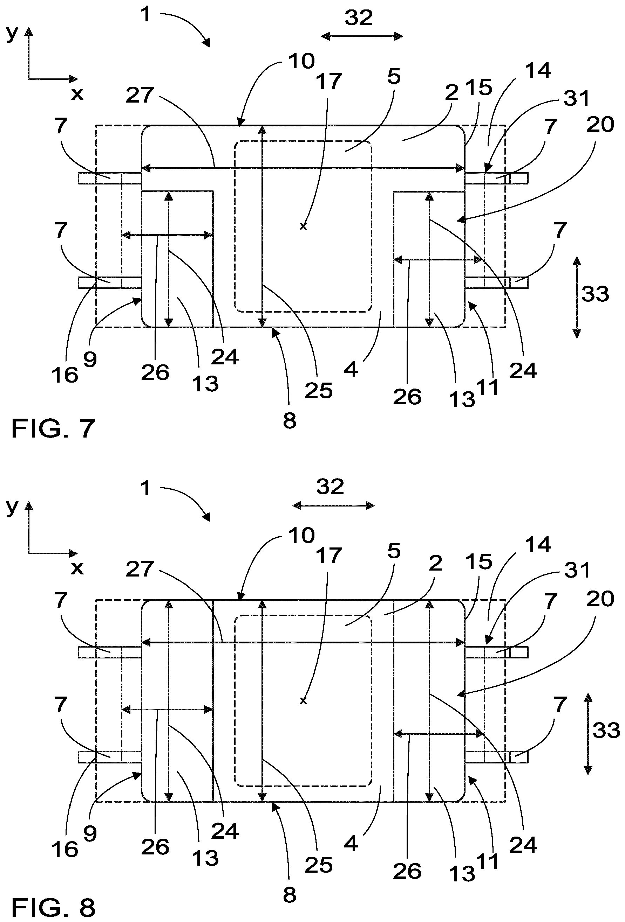

Figure 1 illustrates an electronic component 1 according to an embodiment schematically seen from a first side, and Figure 2 illustrates the embodiment of Figure 1 schematically seen from a second side. Figure 3 illustrates an electronic component according to another embodiment schematically seen from a first side, and Figure 4 illustrates the embodiment of Figure 3 schematically seen from the first side in cross section. Figure 5 illustrates an electronic component according to a further embodiment schematically seen from a first side, and Figure 6 illustrates an electronic component according to a further embodiment schematically seen from a first side. Figures 7-9 illustrate electronic components according to different embodiments schematically seen from the bottom side.

In the figures of this disclosure, the plane defined by the x- and y-axes is parallel to the plane of a printed circuit board (PCB), later called a circuit board in this disclosure, to which the electronic component is configured to be attached. The direction defined by the z-axis is perpendicular to the same plane of the circuit board, or a circuit board plane.

In this disclosure, the words "bottom" and "top" only refer to how the component is configured to be placed with respect to the circuit board. The bottom side of the component is configured to be attached to the surface of the circuit board. Words such as "above" and "below" are used with the same meaning - a first part which is below a second part is configured to be closer to the circuit board, and the second part is provided on the top side of the component with respect to the first part. Words such as "bottom" and "top", "above" and "below", thus, do not refer to the orientation of the component with regard to the direction of earth's gravitational field either when the component is manufactured or when it is in use, although they can in some cases be in agreement with this conventional meaning of top / bottom when the xy-plane is horizontal.

Referring to the axes indicated in the figures, Figures 1 and 3-6 show different embodiments of the electronic component in the direction of the y-axis, Figure 2 shows an embodiment of the electronic component in the direction of the x-axis, and Figures 7-9 show embodiments of the electronic component in the direction of z-axis.

The electronic component 1 comprises a package 2 with a top side 3 and a bottom side 4, at least one electronic chip 5, also called a chip 5 in this disclosure, housed within an enclosure 6 inside the package 2. The package 2 may further comprise, besides the top side 3 and the bottom side 4, four sides: first side 8, second side 9, third side 10 and a fourth side 11.

The package 2 further comprises a plurality of electronic leads 7 protruding from the package 2 and configured to extend from at least two sides, preferably from at least two opposite sides of the package, such as the second side 9 and the fourth side 11 of the package 2 as seen in Figures 1 and 3-6, at least in a first direction 12 extending from the top side 3 of the package 2 towards the bottom side 4 of the package 2. In other words, the electronic leads 7 are configured to protrude from the package 2 at least in a direction corresponding to a downward direction. Thus, the electronic leads 7 are configured to protrude from the package 2 at least towards the side configured to be facing a circuit board 40, when the electronic component 1 is attached to the circuit board 40. According to an embodiment, the electronic leads 7 may further be configured to extend outwards from the package 2, for instance in a bended manner, such as seen in Figure 1 and 3-6.

The package 2 comprises on the bottom side 4 of the package 2 at least one recess 13. The recess 13 is provided within an area 14 defined by outer edges 15, 16 of the package 2 and/or the electronic leads 7. More particularly, the recess 13 is provided within an area 14 defined by outer edges 15, 16 of the package 2 and/or the electronic leads 7, whichever is further from the centre 17 of the package 2. The outer edges 15 of the package 2 refer to the edges of the package 2 that are farthest from a centre 17 of the package 2 in the x-y-plane, in other words on the first side 8, the second side 9, the third side 10 and the fourth side 11. The outer edges 16 of the electronic leads 7 refer to the package side edges of the portions of electronic leads 7 farthest from the centre 17 of the package 2 in the direction extending from the top side 3 of the package 2 towards the bottom side 4 of the package 2. In other words, in embodiments, where the electronic leads 7 have, at a distal end of the electronic leads 7, a portion extending in a direction extending from the second side 9 towards the fourth side 11 or from the first side 8 towards the third side 10, the edges of this portion on the side facing towards the package 2 defines the outer edge 16 of the electronic lead 7 for its part defining the area 14. The centre 17 of the package 2 refers to a centre point measured from the farthest points of the package 2 in the directions of x-, y- and z-axes.

The electronic leads 7 can be used to make electric connections to the electronic chips 5 from an outside of the package 2. In other words, the electronic chips 5 may be connected to the electronic leads 7 inside the package 2, for example by wire bonding or flip chip bonding (not shown), and the electronic leads 7 may extend outward from the package 2 in a side direction which is substantially perpendicular to the z-axis. Electric connections to the electronic chips 5 can then be made by connecting the electronic leads 5 to suitable connectors. According to an embodiment, the electronic lead 7 may be configured to extend outwards from the package 2 in a bended manner in such a way that a first portion of the electronic lead 7 extends from an outer edge 15 of the package 2 in a direction perpendicular to the side 8, 9, 10, 11, on which the electronic lead 7 protrudes from, that a second portion of the electronic lead 7 extends in the first direction 12 between a first bend 31 and the outer edge 16 of the electronic lead 7, and that a third portion extends in a direction parallel to the first portion starting at a second ben at the outer edge 16 of the electronic lead 7. According to an embodiment, the second portion of the electronic lead 7 may extend in a direction perpendicular to the first portion, as shown in Figures 4 and 6. According to another embodiment, the second portion of the electronic lead 7 may extend in an outwards angled manner with respect to the first portion, as shown in Figures 1, 3, 5, 10 and 11.

The recess 13 extends at least from the bottom side 4 towards the top side 3 of the package 2. According to an embodiment, the top side 3 refers to a plane parallel to the plane of the circuit board, to which the electronic component is configured to be attached, comprising the highest point of the package 2 with respect to the plane of the circuit board. According to another embodiment, the top side 3 refers to a plane parallel to a plane 21 defined by bottom surfaces 23 of the electronic leads 7 comprising the highest point of the package 2 with respect to the plane defined by bottom surfaces 23 of the electronic leads 7.

According to an embodiment, a depth 18 of the recess measured from the lowest point of the bottom side 4 towards the top side 3 of the package 2 is in the range of 0.1 mm to 2.0 mm, preferably in the range of 0.2 mm to 1.6 mm. However, in different embodiments, the depth 18 of the recess may vary, and depth 18 may differ considerably from said range depending on the size and structure of the package 2, among other things. According to an embodiment, the depth 18 of the recess measured from the lowest point of the bottom side 4 towards the topside 3 of the package 2 is less than or equal to 75 percent of a height 19 of the package 2. The height 19 of the package 2 refers to the distance between the furthest points of the package 2 in the direction of the z-axis.

According to an embodiment, a width 26 of the recess 13 is measured in a second direction 32 extending from one side 8, 9, 10, 22 of the package 2 provided with electronic leads 7 towards an opposite side 8, 9, 10, 11 of the package 2. According to an embodiment, a width 26 of the recess 13 measured in a second direction 32 extending from one side 8, 9, 10, 22 of the package 2 provided with electronic leads 7 towards an opposite side 8, 9, 10, 11 of the package 2 is in the range of 10 to 100 percent of a width 27 of the package 2. The width 27 of the package 2 refers to the distance between the furthest points of the package 2 in the direction of the x-axis.

According to an embodiment, a length 24 of the recess 13 is measured in a third direction 33, which is a direction perpendicular to the first direction 12 and the second direction 32. According to an embodiment, a length 24 of the recess 13 measured in a third direction 33, which is a direction perpendicular to the first direction 12 and the second direction 32, is in the range of 10 to 100 percent of a length 25 of the package 2. The length 25 of the package 2 refers to the distance between the furthest points of the package 2 in the direction of the y-axis.

The recess 13 is configured to define within the area 14, in other words upwards or towards the package 2 from the area 14, a space 20 between the package 2 and a plane 21 defined by bottom surfaces 23 of the electronic leads 7, more particularly a space 20 defined by the recess 13, the inner surfaces 22 of the electronic leads 7 and the plane 21 defined by bottom surfaces 23 of the electronic leads 7. The space 20 is, thus, also limited by planes from the sides 8, 9, 10, 11 towards the area 14, more particularly extending in the direction of the z-axis, on sides 8, 9, 10, 11 which are not provided with electronic leads 7. According to an embodiment, the space 20 is designed to receive at least one discrete component 41. In other words, the space 20 may be dimensioned to receive the at least one discrete component 41 within the space 20.

Discrete components 41 are components used in connection with circuit boards 40, which comprise a single component or electrical device, as opposed to for instance integrated circuit packages comprising multiple components contained in a single package. For circuit boards, a discrete component 41 can be provided as a through-hole package or a surface mount device (SMD). According to an embodiment, the discrete component 41 may comprise a passive component, in other words a component that doesn't generate power or electrical energy. According to another embodiment, the discrete component 41 may comprise an active component.

According to an embodiment, the recess 13 is provided at least on one side 8, 9, 10, 11 of the package 2 and extends to an outer edge 15 of the package 2 at least on that side 8, 9, 10, 11. In other words, the recess 13 may open at least to the side 8, 9, 10, 11 on which it is provided, such as in the embodiments of Figures 1-11. According to an embodiment, the recess 13 extends to an outer edge 15 of the package 2 at least on two adjacent sides 8, 9, 10, 11, such as on the first side 8 and the second side 9 or on the first side 8 and the fourth side 11 of the package 2, such as in embodiments of Figures 1-4 and 6-11. According to a further embodiment, the recess 13 extends to an outer edge 15 of the package 2 on three adjacent sides 8, 9, 10, 11, such as in the embodiments of Figures 6, 8 and 11.

According to an embodiment, at least two recesses 13 according to an embodiment or a combination of embodiments described in this description and accompanying drawings and claims are provided each on one side 8, 9, 10, 11 of the package 2. According to an embodiment, the two recesses 13 are provided on opposite sides 8, 9, 10, 11 of the package 2, such as in the embodiments of Figures 1, 6-8 and 10-11. According to an embodiment, the two recesses 13 both extend to an outer edge 15 of the package on respective opposite sides 8, 9, 10, 11 and also on a same side 8, 9, 10, 11 extending between said opposite sides, such as in the embodiments of Figures 1, 6-8 and 10-11.

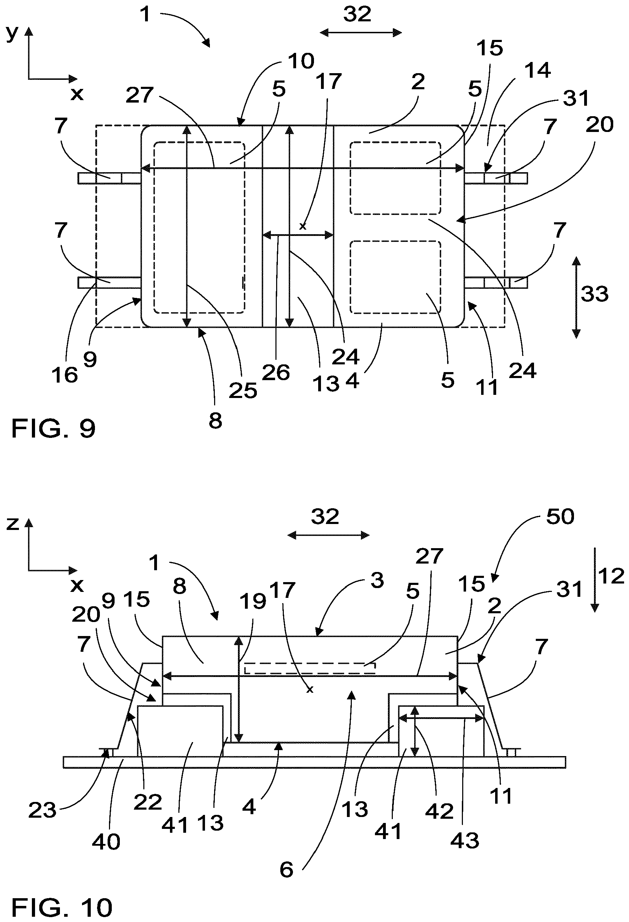

According to an embodiment, the recess 13 extends to an outer edge 15 of the package 2 on two opposite sides 8, 9, 10, 11, such as on the first side 8 and the third side 10 or on the second side 9 and the fourth side 11 of the package 2, such as in the embodiment of Figure 9.

According to an embodiment, such as in the embodiments of Figures 1-5 and 10, the package 2 may comprise a case formed as a single structural part.

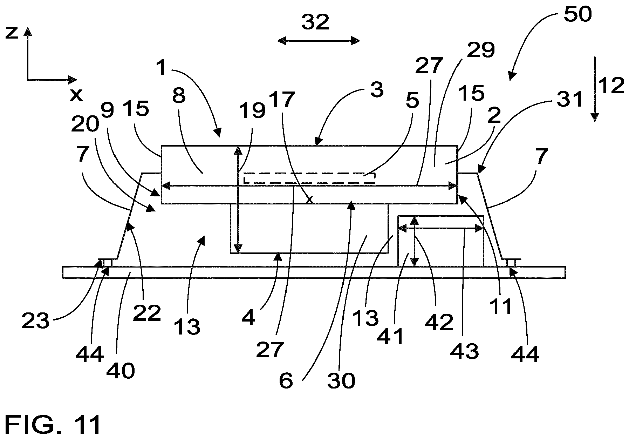

According to an embodiment, such as in the embodiments of Figures 6 and 11, the package 2 may comprise a package base 29. According to an embodiment, the package base may be provided on the top side 3 of the package 2 and, thus, the electronic component 1. According to an embodiment, the package base 29 may comprise a chip mounting element 28, as illustrated in Figure 2, to which mounting element 28 at least one electronic chip 5 is attached.

According to an embodiment, the package 2 may further comprises a cap 30. According to an embodiment, the cap 30 may be provided on the bottom side 4 of the package 2 and, thus, the electronic component 1. According to an embodiment, the one or more recesses 13 may be provided in the cap 30.

According to an embodiment, the at least one electronic chip 5 may be separated from the cap 30 by a gap and the cap 30 may be attached to the package base 29 to form the enclosure 6. According to an embodiment, the bottom surface of the cap 30 may be configured to be parallel to the plane of the circuit board, or a circuit board plane. The gap may comprise for instance an air gap.

According to an embodiment, the cap may be formed from a metal, such as stainless steel, copper, nickel-cobalt ferrous alloy, such as Kovar, etc.

According to an embodiment, the electronic component 1 may comprise a package base 29 and a cap 30, and the package base and the cap may together form the enclosure 6. According to an embodiment, the cap 30 may form the bottom side 4 of the package 2.

According to an embodiment, the package base 29 may for instance be made of plastic. According to an embodiment, the package base 29 may be manufactured in a moulding process where the package base 29 is moulded around a leadframe, where the chip mounting element 28 and electronic leads 7 have been formed. Other methods can also be used to form a plastic package base 29. The package base 29 may alternatively be made of a ceramic material. The cap 30 can be attached to the package base 29 with glue or with any other method. The attachment region where the cap 30 is attached to the package base 29 may encircle the enclosure 6.

Figure 10 illustrates an arrangement according to an embodiment seen from a first side and Figure 11 illustrates an arrangement according to another embodiment seen from a first side.

According to an aspect, an arrangement 50 comprises an electronic component 1 according to an embodiment or a combination of embodiments disclosed in this description and/or the accompanying drawings or claims and at least one discrete component 41 provided in the at least one recess 13 provided in the package 2. More particularly, the discrete component 41 may be provided in the space 20 between the package 2 and the plane 21 defined by bottom surfaces 23 of the electronic leads 7. According to an embodiment, two or more discrete components 41 are provided in the at least one recess 13. According to an embodiment, the package 2 comprises two or more recesses 13 and the arrangement comprises two or more discrete components 41 provided in one or more of the recesses 13.

According to an embodiment, the discrete component 41 comprises a standard size discrete component. Such standard size discrete components and their dimensions are defined for instance in EIA-198 and IEC/EN. According to an embodiment, the at least one recess 13 has a depth 18, a width 26 and a length 24 greater than a respective depth, width and length of the standard size discrete com ponent 41. According to an embodiment, the height 42 of the standard size discrete component 41 is in the range of 0.2 to 2.5 mm, preferably in the range of 0.5 mm to 1.0 mm. According to an embodiment, the width 43 of the standard size discrete component 41 is in the range of 0.2 to 2.5 mm. According to an embodiment, the length (not shown) of the standard size discrete component 41, namely the dimension measured in a direction perpendicular to the height 42 and the width 43 of the discrete component 41, is in the range of 0.4 to 5.0 mm. In different embodiments, the dimensions may vary.

Many devices require additional discrete components 41 to function in an intended manner. In the embodiments disclosed in this disclosure, the discrete components 41 can be provided in the recesses within the are 14 defined by the outer edges 15, 16 of the package 2 and the electronic leads 7, instead of requiring additional space on the circuit board 40 surface. The discrete component 41 may comprise any discrete component. According to an embodiment, the discrete component may comprise a passive discrete component, such as a resistor, a capacitor, an inductor, a substrate, or another passive discrete component configured to be attached to the circuit board 40.

According to an embodiment of the arrangement, the electronic component 1 according to an embodiment or a combination of embodiments disclosed in this description and/or accompanying drawings or claims, may be attached to a surface of the circuit board 40. In such embodiments, the space 20 is formed between the package 2 and surface of the circuit board 40 facing towards the electronic component 1. More particularly, the space 20 is defined by the recess 13, the inner surfaces 22 of the electronic leads 7 and the surface of the circuit board facing towards the electronic component 1.

According to an embodiment, the case or the cap 30 may be attached to the surface of the circuit board 40 at one or more attachment points 44, as illustrated in Figure 11. The attachment can be provided for instance by soldering or with an adhesive. At least one discrete component may be provided in at least one recess 13 provided in the package 2.

According to an embodiment, the package 2, depending on the embodiment the case or the cap 30, may be attached to the surface of the circuit board 40. Different kind of components may be provided inside the enclosure 6, but such components and structures are not relevant for this disclosure and are not explained in more detail.

According to an embodiment, the package 2, such as the case or the package base 29, may house two or more electronic chips 5, such as in the embodiments of Figures 5 and 9. According to an embodiment, each one of the electronic chips may be attached to a chip mounting element 28.

The electronic leads 7, which may also be called electric contacts, may extend to the surface of the circuit board 40 and to an electric contact pad (not shown) on the surface of the circuit board 40. According to an embodiment, the electronic leads 7 may extend substantially in the same plane, in other words at a substantially same z-coordinate, as the bottom surface of the cap 30.

Different alternatives are available for facilitating the mechanical attachment of the electronic component 1 to a circuit board 40. For example, substantially the whole bottom of the package 2, such as the case or the cap 30, may be coated with a solder pad material to form a solder pad which extends across substantially the whole bottom side 4 of the package 2, or dedicated regions of the bottom side 4 of the package 2 may be coated with the solder pad material to form solder pads only in these regions. The solder pad/pads on the package may then be attached to one or more solder pads on the surface of a circuit board 40 with a solder material.

According to another embodiment, the package 2 may be attached to solder pads on the surface of the circuit board 40 with an adhesive and a solder material. The adhesive may be in contact with the bottom side 4 of the package 2, and a metallic plate may be placed between the adhesive and the solder material which fixes the package 2 to a solder pad on the circuit board. The adhesive may comprise a viscoelastic material. The viscoelastic material may be attached either directly to the package 2 or to an attachment pad formed with a solder pad material or any other suitable material on the package 2.

According to a further embodiment, one or more areas on the bottom side 4 of the package 2 may be coated with a solder pad material to form solder pads in said one or more areas of the bottom side 4 of the package 2. These solder pads on the package 2 may then be attached to the surface of a circuit board 40 with a solder material. Corresponding solder pads may be present on the surface of the circuit board 40. Another alternative is to form solder pads on the surface of the circuit board 40 and to solder them directly to the package 2 without forming a separate solder pad on the package 2 for this purpose. Depending on the selected materials, a soldered attachment can be made with or without solder pads on the side of the package 2, and with or without solder pads on the circuit board 40.

## Claims

1. An electronic component comprising
a package with a top side and a bottom side,
at least one electronic chip housed within an enclosure inside the package, and
a plurality of electronic leads protruding from the package and configured to extend from at least two sides of the package at least in a first direction extending from the top side of the package towards the bottom side of the package, **characterized in that** the package comprises on the bottom side of the package at least one recess, wherein the recess is provided within an area defined by outer edges of the package and the electronic leads, extends at least from the bottom side towards the top side of the package, and is configured to define within said area a space between the package and a plane defined by bottom surfaces of the electronic leads, which space is designed to receive at least one discrete component.

2. An electronic component according to claim 1, wherein the recess is provided at least on one side of the package and extending to an outer edge of the package at least on said side.

3. An electronic component according to claim 1 or 2, wherein the recess extends to an outer edge of the package at least on two adjacent sides.

4. An electronic component according to any one of claims 1 - 3, wherein at least two such recesses are provided each on one side of the package.

5. An electronic component according to any one of claims 1 - 4, wherein two such recesses are provided on opposite sides of the package.

6. An electronic component according to claim 4 or 5, wherein the two recesses both extend to an outer edge of the package on respective opposite sides and also on a same side extending between said opposite sides.

7. An electronic component according to any one of claims 1 - 6, wherein a depth of the recess measured from the lowest point of the bottom side towards the top side of the package is in the range of 0.1 mm to 2.0 mm.

8. An electronic component according to any one of claims 1 - 7, wherein a width of the recess measured in a second direction extending from one side of the package provided with electronic leads towards an opposite side of the package is in the range of 10 to 100 percent of a width of the package.

9. An electronic component according to any one of claims 1 - 8, wherein a length of the recess measured in a direction perpendicular to the first direction and the second direction is in the range of 10 to 100 percent of the width of the package.

10. An electronic component according to any one of claims 1 - 9, wherein the package comprises a case formed as a single structural part.

11. An electronic component according to any one of claims 1 - 9, wherein the package comprises a package base provided on the top side of the package and a cap provided on the bottom side of the package, and wherein the one or more recesses is provided in the cap.

12. An arrangement comprising
an electronic component according to any one of claims 1-11 and
at least one discrete component provided in the at least one recess provided in the package.

13. An arrangement according to claim 12, wherein the arrangement further comprises a circuit board, the electronic component 1 is attached to a surface of the circuit board, and the at least one discrete component is provided in a space formed between the package and a surface of the circuit board facing towards the electronic component.

14. An arrangement according to claim 12 or 13, wherein the discrete component comprises a standard size discrete component and wherein the at least one recess has a depth, a width and a length greater than a depth, a width and a length of the discrete component.

15. An arrangement according to any one of claims 12 - 14, wherein the discrete component(s) comprises at least one of the following: a resistor, a capacitor, an inductor, and a substrate.
